Europäisches Patentamt

European Patent Office

Office européen des brevets

(11) Veröffentlichungsnummer: **0 501 291 A1**

## (12) EUROPÄISCHE PATENTANMELDUNG

(21) Anmeldenummer: **92102727.2**

(22) Anmeldetag: **19.02.92**

(51) Int. Cl.⁵: **H05K 7/14**

(30) Priorität: **27.02.91 DE 9102333 U**

(43) Veröffentlichungstag der Anmeldung:
**02.09.92 Patentblatt 92/36**

(84) Benannte Vertragsstaaten:
**AT BE CH DE DK ES FR GB IT LI NL SE**

(71) Anmelder: **Standard Elektrik Lorenz Aktiengesellschaft**
**Lorenzstrasse 10**
**W-7000 Stuttgart 40(DE)**

(72) Erfinder: **Hüeber, Fritz**
**Einsteinstrasse 6**
**W-7143 Vaihingen/Enz(DE)**

(74) Vertreter: **Pohl, Herbert, Dipl.-Ing et al**
**Standard Elektrik Lorenz AG Patent- und**
**Lizenzwesen Postfach 30 09 29**
**W-7000 Stuttgart 30(DE)**

(54) **Gestell der Fernmeldetechnik.**

(57) Das Gestell (1) enthält übereinander angeordnete Baugruppenträger (4) mit mehrere Zeilen übergreifenden Seitenwänden (7). Jeweils eine horizontale obere Schiene eines Baugruppenträgers und die untere des darüber befindlichen Baugruppenträgers wird von einer einstückigen Schiene (9) mit Doppelprofil gebildet. Sie ist auf der Vorderseite mit abgestuften Nuten (17) versehen, in die stirnseitig Schrauben (30) zur Befestigung der Seitenwände (7) eindrehbar und Erdungs- oder Befestigungsstreifen (19) zum Anschrauben von beispielsweise Verdrahtungsrückwänden (13) einschiebbar sind.

Fig. 2

EP 0 501 291 A1

Die Erfindung betrifft ein Gestell der Fernmeldetechnik mit Baugruppenträgern nach dem Oberbegriff des Anspruchs 1.

Ein derartiges Gestell ist in dem Artikel "System 12 Bauweise" in der Zeitschrift Elektrisches Nachrichtenwesen, Band 56, Nr. 2/3, 1981, Seiten 283 bis 292 beschrieben. Zwischen den vertikalen Seitenholmen des Gestellrahmens sind die Baugruppenträger oder -rahmen übereinander montiert, die zur Aufnahme steckbarer Baugruppen dienen und deshalb jeweils oben und unten mit Führungsschienen sowie rückseitig mit einer Verdrahtungsrückwand und Steckkontaktleisten ausgerüstet sind. Die beiden rechteckigen Seitenwände der Baugruppenträgern sind jeweils aus Blech und in den Ecken durch vier Schienen miteinander verbunden. Diese horizontalen Schienen sind Profilschienen, in die Lochstreifen einschiebbar sind, so daß zum Beispiel die Verdrahtungsrückwände mit Schrauben befestigt werden können.

Profilschienen dieser Art sind auch aus der DE 23 47 902 B2 bekannt, wobei das rechteckige Profil von der einen Schmalseite her geschlitzt ist. Der Schlitz erstreckt sich mittig zwischen den Breitseiten, ist nahe der Schmalseite durch Nute nach beiden Seiten erweitert, um eine Führung für einschiebbare (Loch-)Streifen zu schaffen. Im übrigen können die Schlitzwandungen gerillt sein, um das Eindrehen von Schrauben zu erleichtern. Andererseits kann die Legierung des Strangpreßprofils so weich sein, daß sich mit selbstschneidenden Schrauben mühelos Bauteile, wie Kontaktleisten oder dergleichen, befestigen lassen. Im Grund ist der Schlitz im Querschnitt kreisförmig erweitert, damit sich beim Montieren der Baugruppenträger Schrauben stirnseitig in die Profilschienen eindrehen lassen, um letztere mit den Seitenwänden zu verbinden.

Bei der Montage der Gestelle tritt das Problem auf, daß die Breite der Baugruppenträger infolge von Fertigungstoleranzen beim Längenzuschnitt der Profilschienen differiert, was im Extremfall dazu führt, daß benachbarte Baugruppenträger soweit voneinander abweichen, daß bei dem kürzeren ein Längenausgleich erforderlich wird. Aus dem gleichen Grund ist es sehr schwierig, mit den Einfachprofilschienen mehrzeilige Baugruppenträger mit durchgehenden Seitenwänden zu bilden. Außerdem können sich die unteren Schienen der Baugruppenträger bei Bestückung mit schweren Baugruppen durchbiegen.

Der Erfindung liegt die Aufgabe zugrunde, die geschilderten Nachteile zu vermeiden und die Konstruktion so zu verbessern, daß die Festigkeit der Baugruppenträger erhöht wird und die Fertigungskosten gesenkt werden. Gelöst wird diese Aufgabe durch die im Anspruch 1 angegebenen Merkmale. Weiterbildungen sind den Unteransprüchen zu entnehmen. Die Vorteile der erfindungsgemäßen Konstruktion sind in der folgenden Beschreibung erwähnt.

Die Erfindung wird an einem Ausführungsbeispiel beschrieben, das in den zugehörigen Zeichnungen dargestellt ist. Darin zeigen:

Fig. 1    ein Gestell der Fernmeldetechnik in perspektivischer Ansicht;

Fig. 2    einen Baugruppenträger aus dem Gestell nach Fig. 1, in vergrößerter perspektivischer Ansicht;

Fig. 3    eine der rückwärtigen Schienen des Baugruppenträgers nach Fig. 2 mit angeschraubten Verdrahtungsrückwänden, in Teilausschnitten, sowie einen Teil einer Seitenwand für die Befestigung der Schiene, in vergrößerter perspektivischer Rückansicht;

Fig. 4    eine der rückwärtigen Schienen wie in Fig. 3, jedoch mit vertikal durchlaufender, angeschraubter Verdrahtungsrückwand.

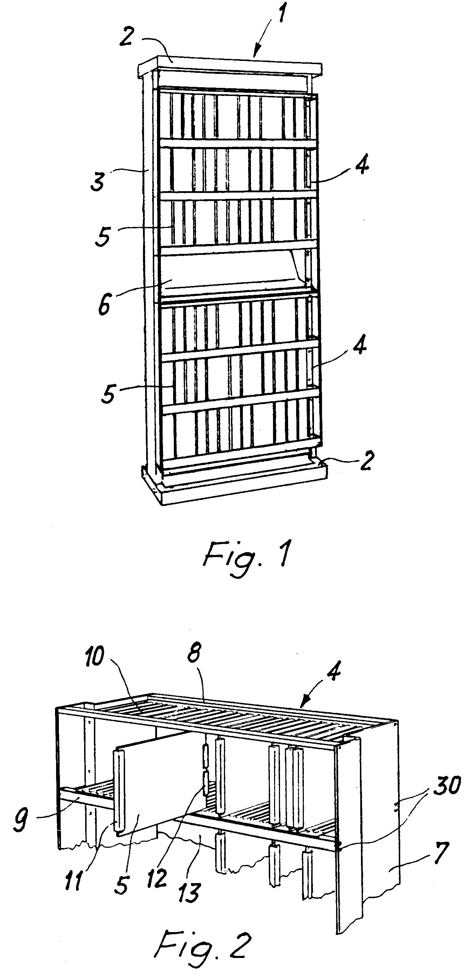

Die Fig. 1 zeigt ein Gestell 1, wie es in der Fernmeldetechnik, insbesondere in der Fernsprechvermittlungstechnik zum Einsatz kommt und wie es im prinzipiellen Aufbau aus dem Stand der Technik bekannt ist. Im wesentlichen weist das Gestell 1 einen Gestellrahmen auf, der aus einem oberen und einem unteren Querrahmen 2 und zwei diese verbindenden Seitenholmen 3 besteht. Zwischen letzteren sind Baugruppenträger 4 befestigt, die zur Aufnahme steckbarer Baugruppen 5 dienen, welche die elektrischen Schalteinrichtungen tragen. Jeder Baugruppenträger 4 umfaßt drei Reihen oder Zeilen Baugruppen 5. Der obere und der untere Baugruppenträger sind gleich. Dazwischen ist eine Wärmeleitvorrichtung 6 angebracht, die den Raum einer Zeile einnimmt. Erwähnt sei noch, daß das Gestell einerseits durch Türen und Verkleidungsbleche zu einem Schrank ergänzt und andererseits durch weitere Gestelle zur Gestell- oder Schrankreihe ausgebaut werden kann.

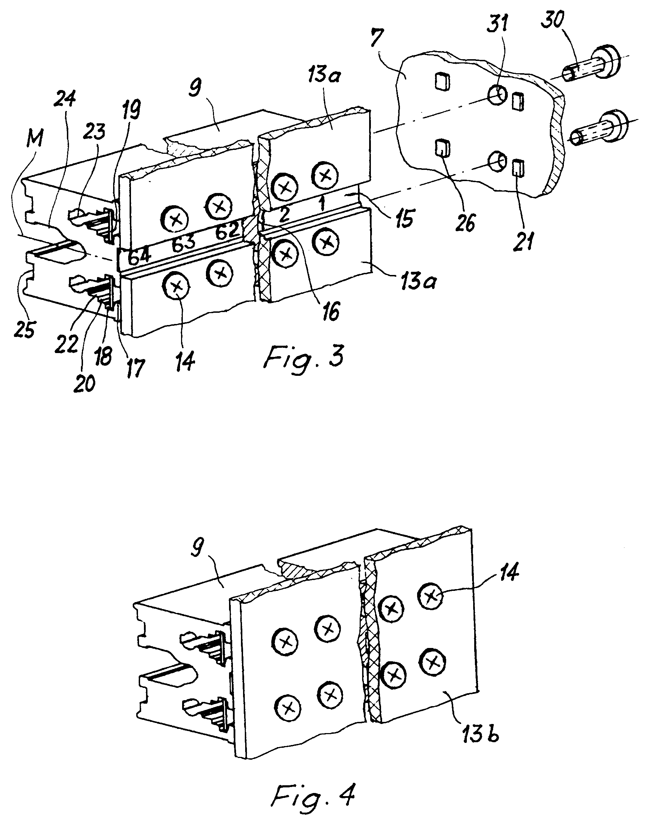

In Fig. 2 ist einer der beiden Baugruppenträger 4 aus dem Gestell 1 herausgenommen und in halber Höhe abgebrochen dargestellt. Die beiden Seitenwände 7 sind durch horizontale Schienen 8 und 9 miteinander verbunden. Während beim Stand der Technik jede Zeile von einem separaten Baugruppenträger gebildet wird, dessen Schienen aus Einfachprofilen zugeschnitten sind, erstrecken sich bei der vorliegenden Konstruktion die Seitenwände 7 über drei Zeilen und nur die oberen Schienen 8 sind Einfachprofile. Die darunter liegenden Schienen 9 werden von Doppelprofilen gebildet und stellen die Zusammenfassung zweier Einfachprofilschienen dar. Der Vorteil dieser Ausführung liegt einmal im Längenzuschnitt der Schienen, der großzügiger toleriert werden kann, weil nicht zwei Schienen unterschiedlicher Länge unmittelbar nebeneinander zu liegen kommen, und zum anderen in der größeren Belastbarkeit der Schienen, die sich auch bei voller Bestückung mit Baugruppen 5 nicht durchbiegen. Außerdem kann die Montage vereinfacht werden, da die Schienen 9 je nach Belastung jeweils mit einer oder mit zwei Schrauben an der Seitenwand 7 befestigt werden können, was anhand der Fig. 3 noch verdeutlicht wird.

Aus Fig. 2 ist noch ersichtlich, daß an den horizontalen Schienen 8 und 9 Führungsschienen 10 angebracht sind, in die die Baugruppen 5 einschiebbar sind. Letztere sind stirnseitig mit Griffleisten 11 und rückseitig mit Steckkontaktleisten 12 ausgerüstet, die beim Einstecken mit komplementären Kontaktleisten an der Verdrahtungsrückwand 13 zusammen wirken. Die Verdrahtungsrückwand ist auf der Rückseite am Baugruppenträger 4 befestigt.

In Fig. 3 ist eine der Schienen 9 mit doppeltem Profil vergrößert dargestellt, und zwar eine der rückseitig am Baugruppenträger angebrachten, sowie ein Ausschnitt aus einer Seitenwand 7 des Baugruppenträgers 4 und Schrauben 30 zur Befestigung der Schiene, vor der Montage. An dieser Schiene 9 sind zwei Verdrahtungsrückwände 13a mit Schrauben 14 befestigt. Diese Rückwände bedecken jeweils die Rückseite einer Zeile des Baugruppenträgers. Zwischen beiden Verdrahtungsrückwänden 13a ist Raum für einen Bezeichnungsstreifen 15, für den eine passende Einlegenut 16 geringer Tiefe in der Schiene vorgesehen ist.

Das Profil der Schiene 9 ist im wesentlichen rechteckig und bezüglich einer horizontalen Mittelebene M symmetrisch gestaltet, die durch eine strichpunktierte Linie angedeutet ist. Die Einlegenut 16 schneidet die Mittelebene. Oberhalb und unterhalb ist je eine mehrfach abgestufte Nut 17 in die Schiene 9 eingelassen. Nach außen öffnet sich die Nut 17 in einer Breite, die nur wenig größer ist als der Schaft der Schrauben 14, die zur Befestigung der Verdrahtungsrückwände 13a dienen, um deren Durchtritt durch die Nut zu erlauben. Danach erweitert sich die Nut nach beiden Seiten auf etwa die doppelte Breite. Dieser Teil 18 der Nut ist für die Aufnahme eines Befestigungsstreifens 19 oder eines gezähnten Erdungsstreifens (nicht dargestellt) vorgesehen, der an der Stirnseite eingeschoben wird. Er ist mit Gewindelöchern versehen, in die die Schrauben 14 eingedreht werden. Der Erdungsstreifen ist außerdem mit herausgedrückten Zähnen versehen, die z.B. am Rand aus der Oberfläche vorstehen und beim Festdrehen der Schrauben 14 in Nutflächen der Schiene gepreßt werden. Dadurch wird über die Schraube eine gute Erdung von einer entsprechenden Leiterbahn auf der Verdrahtungsrückwand 13a zur Schiene 9 und von dieser über die Seitenwände 7 zum Gestell 1 hergestellt.

An der nächsten Stufe wird die Nutbreite wieder reduziert. Diesem schmaleren Teil 20 der Nut entsprechen rechteckige Warzen oder Ansätze 21 an der Seitenwand 7, die bei der Montage stirnseitig in diesen Teil 20 der Nut als Lagesicherung eingreifen. Durch eine weitere Abstufung wird die Nutbreite nochmals verringert, dieser schmale Teil 22 dient als Auslauf für die Enden der Schrauben 14 und stellt die Verbindung zum Nutengrund dar. Der Nutengrund hat runden Querschnitt und ist als Kernloch 23 für selbstformende Schrauben 30 vorgesehen, die bei der Montage von außen durch entsprechende Löcher 31 in der Seitenwand 7 gesteckt und stirnseitig in die Schiene 9 geschraubt werden. Wie erwähnt, ist bis zu einer bestimmten Belastung der Schiene 9 je Seite eine Schraube 30 zur Befestigung an der Seitenwand 7 ausreichend, erst bei noch größerer Belastung sind zwei Schrauben je Seite erforderlich.

Von der gegenüberliegenden oder Rückseite der Schiene 9 erstreckt sich in der Mittelebene eine relativ breite, U-förmige Nut 24 etwa bis in Höhe der Kernlöcher 23, die der Material- bzw. Gewichtsersparnis dient. Beiderseits dieser Nut 24 sind je eine kleine rechteckige Nut 25 in der Rückseite eingelassen. In diese greifen bei der Montage wiederum entsprechende Ansätze 26 ein, die aus der Seitenwand 7 vorstehen und der Lagesicherung dienen.

Fig. 4 zeigt eine gleiche Schiene 9 wie Fig. 3, jedoch mit einer mehrere Zeilen überdeckenden, also vertikal durchlaufenden, angeschraubten Verdrahtungsrückwand 13b. Die Nut 16 für einen Bezeichnungsstreifen ist dadurch verdeckt. Alle übrigen Einzelheiten entsprechen den zuvor bei Fig. 3 beschriebenen.

Neben den bereits erwähnten Vorteilen lassen sich durch den Einsatz der Doppelprofilschienen 9 auch die Kosten für einen Baugruppenträger senken, zum einen, weil eine Doppelprofilschiene billiger ist als zwei Einzelprofilschienen und zum anderen, weil die Anzahl der Befestigungsschrauben z.B. bei einem dreizeiligen Baugruppenträger um ein Drittel reduziert werden kann.

**Patentansprüche**

1.  Gestell der Fernmeldetechnik mit übereinander angebrachten, zur Halterung steckbarer Baugruppen vorgesehenen Baugruppenträgern, die jeweils von zwei Seitenwänden und diese verbindenden, horizontalen Schienen gebildet werden, wobei letztere als Träger für Führungsschienen, in welchen eingeschobene Baugruppen oben und unten gehaltert werden, sowie für Verdrahtungsrückwände mit Steckkontaktleisten zum elektrischen Anschluß der Baugruppen dienen,

**dadurch gekennzeichnet,** daß jeweils eine horizontale obere Schiene eines Baugruppenträgers (4) und die untere des darüber befindlichen Baugruppenträgers von einer einstückigen Schiene (9) mit Doppelprofil gebildet wird, die symmetrisch zu einer Mittelebene (M) ausgebildet und auf der Vorderseite mit zwei Nuten (17) versehen ist, in die stirnseitig Schrauben (30) zur Befestigung der Seitenwände (7) eindrehbar sind.

2. Gestell nach Anspruch 1, dadurch gekennzeichnet, daß die Nute (17) der Schiene (9) jeweils mit hintereinander liegenden Abstufungen (18, 20, 22) für den Durchtritt von Schrauben (14), für die Aufnahme eines stirnseitig einschiebbaren Befestigungsstreifens (19) oder Erdungsstreifens, für den stirnseitigen Eingriff von Ansätzen (21) der Seitenwände (7) sowie im Nutengrund als Kernloch (23) für die stirnseitig eindrehbaren Schrauben (30) ausgestaltet sind.

3. Gestell nach Anspruch 2, dadurch gekennzeichnet, daß auf der Vorderseite der Schiene (9) mittig zwischen den beiden abgestuften Nuten (17) eine weitere, flache Einlegenut (16) für Bezeichnungsstreifen (15) angebracht ist.

4. Gestell nach Anspruch 2 oder 3, dadurch gekennzeichnet, daß die Schiene (9) auf der Rückseite eine V-förmige Nut (24) in der Symmetrieebene (M) sowie zwei Nute (25) für den stirnseitigen Eingriff von Zentrieransätzen (26) der Seitenwände (7) aufweist.

5. Gestell nach Anspruch 4, dadurch gekennzeichnet, daß die Doppelprofilschiene (9) ein Strangpreßteil aus einer Aluminiumlegierung ist.

6. Gestell nach Anspruch 1, dadurch gekennzeichnet, daß die Seitenwände (7) des Baugruppenträgers (4) mehrere Reihen oder Zeilen für Baugruppen (5) umfassen, wobei die obersten Schienen (8) wahlweise Einfach- oder Doppelprofil haben.

Fig. 1

Fig. 2

Fig. 3

Fig. 4

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | US-A-3 377 515 (P.F. ERB) <br> * das ganze Dokument * <br> --- | 1 | H05K7/14 |
| A | DE-U-8 533 398 (STANDARD ELEKTRIK LORENZ AG) <br> * das ganze Dokument * <br> --- | 1 | |
| A | US-A-4 013 928 (SARINOPOULOS ET AL.) <br> * das ganze Dokument * <br> --- | 1 | |
| A,D | DE-A-2 347 902 (INTERNATIONAL STANDARD ELECTRIC CORP.) <br> * das ganze Dokument * <br><br> ----- | 1 | |

**RECHERCHIERTE SACHGEBIETE (Int. Cl.5)**

H05K

Der vorliegende Recherchenbericht wurde für alle Patentansprüche erstellt

| Recherchenort | Abschlußdatum der Recherche | Prüfer |
|---|---|---|
| DEN HAAG | 01 JUNI 1992 | TOUSSAINT F.M.A. |

KATEGORIE DER GENANNTEN DOKUMENTE

X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur

T : der Erfindung zugrunde liegende Theorien oder Grundsätze
E : älteres Patentdokument, das jedoch erst am oder nach dem Anmeldedatum veröffentlicht worden ist
D : in der Anmeldung angeführtes Dokument
L : aus andern Gründen angeführtes Dokument
................................................................
& : Mitglied der gleichen Patentfamilie, übereinstimmendes Dokument